# NEUE EUROPÄISCHE PATENTSCHRIFT

(11) **EP 1 880 398 B2**
(45) Veröffentlichungstag und Bekanntmachung des Hinweises auf die Entscheidung über den Einspruch: **01.01.2014**
(45) Hinweis auf die Patenterteilung: 16.09.2009
(21) Anmeldenummer: 06742811.0
(22) Anmeldetag: 05.05.2006
(51) Int. Cl.: H01F 27/00, H01F 17/00, H05K 13/00, H01Q 7/00

(54) **ELEKTRONISCHES BAUTEIL UND VERFAHREN ZU SEINER BEFESTIGUNG**
ELECTRONIC COMPONENT AND METHOD FOR FIXING THE SAME
COMPOSANT ELECTRONIQUE ET PROCEDE DE FIXATION

(30) Priorität: 13.05.2005 DE 102005022927
(43) Veröffentlichungstag der Anmeldung: 23.01.2008
(73) Patentinhaber: Würth Elektronik IBE GmbH, 94136 Thyrnau (DE)
(72) Erfinder: AUMÜLLER, Rupert, 94491 Hengersberg (DE)
(74) Vertreter: Patentanwälte Ruff, Wilhelm, Beier, Dauster & Partner
(86) Internationale Anmeldenummer: PCT/EP2006/004206
(87) Internationale Veröffentlichungsnummer: WO 2006/122660

(56) Entgegenhaltungen:
- EP-A1- 1 403 887
- EP-A1- 1 439 551
- EP-A2- 0 845 792
- EP-B1- 0 950 251
- WO-A-96/19814
- DE-A1- 2 345 102
- DE-A1- 3 615 307
- DE-A1- 3 927 690
- DE-A1- 10 016 974
- DE-A1- 10 322 628
- DE-A1- 19 744 455
- DE-A1- 19 812 836
- DE-A1- 19 922 122
- DE-U1- 9 410 532
- DE-U1- 29 707 641
- US-A- 5 307 041

## Beschreibung

Die Erfindung betrifft ein elektronisches Bauteil, insbesondere eine Spule und ein Verfahren zu ihrer Herstellung.

Spulen mit Spulenkernen werden in der Elektronik häufig benötigt. Sie werden in Bauteile, Leiterplatten oder sonstige Einrichtungen eingesetzt und dort befestigt. Das Einsetzen und Befestigen geschieht häufig mit Hilfe von Geräten, die die Spulen ergreifen und an Ort und Stelle absetzen. Nach dem Absetzen können sie beispielsweise automatisch zur Herstellung der elektrischen Verbindung verlötet werden.

Bei dem Bewegen der Spulen mit Hilfe von automatischen Einrichtungen können sehr hohe Geschwindigkeiten auftreten, insbesondere auch ruckartige Beschleunigungen. Bei dem Auftreten ruckartiger Beschleunigungen besteht die Gefahr, dass die Spulenkerne aus der Spulenwicklung heraus geschleudert werden. Üblicherweise sind die Spulenkerne zwar geringfügig länger als die Spulenwicklung, aber das Angreifen mit automatischen Einrichtungen geschieht in der Regel in der Mitte der Längserstreckung der Spule, also an der Spulenwicklung.

Um das Angreifen an der Spulenwicklung zu ermöglichen, ist es bereits bekannt, ein Plättchen aus Kunststoff mit Hilfe eines Klebers, bei dem es sich um Vergussmasse handeln kann, an der Oberseite der Spulenwicklung anzubringen (DE 9410532 U).

Weiterhin ist ein elektrisches Bauteil, insbesondere eine Spule für die SMD-Montagetechnik bekannt (WO 96/19814), bei dem auf die Spule ein Massepunkt aus einer Vergussmasse aufgebracht wird. Dieser Massepunkt kann zum Angreifen eines Greifers dienen.

Es ist bereits ein elektronisches Bauelement in Form einer Spule mit einem Spulenkörper bekannt, der einen zylindrischen Spulenkern und diesen begrenzende Flansche aufweist. Auf den Spulenkern ist eine Spule mit Abstand zwischen den Windungen aufgewickelt, und über die gesamte Länge des Spulenkerns wird ein Lack aufgebracht, der in den Zwischenräumen zwischen den Windungen die Isolierung zwischen diesen vergrößert (EP 0845792 A2, Figur 14). An der Außenseite des Lacks kann ein Greifer angreifen.

Weiterhin ist eine Spule mit einem zylindrischen Spulenkern und einer Spulenwindung bekannt, bei der die Enden der Spulenwindung nach innen abgebogen sind und an den Stirnflächen des Spulenkerns anliegen. Damit soll ein Herausfallen der Kerne aus den Spulenwindungen verhindert werden. Die Spulen werden in Vertiefungen eines Bandes transportiert (EP 1403887 A1).

Der Erfindung liegt die Aufgabe zu Grunde, ein elektronisches Bauteil so auszubilden, dass es sich für die automatische Montage besonders eignet.

Zur Lösung dieser Aufgabe schlägt die Erfindung ein Bauteil mit den im Anspruch 1 genannten Merkmalen und ein Verfahren mit den Merkmalen des Anspruchs 9 vor. Weiterbildungen der Erfindung sind Gegenstand von Unteransprüchen.

Das Bauelement kann also durch Angreifen eines Greifers an dem Haltelement ergriffen und an die Montagestelle bewegt werden.

Im Normalfall liegen die Windungen der Spulenwicklung aneinander an, um möglichst wenig Platz zu benötigen. Nun ist erfindungsgemäß vorgesehen, dass an einer Stelle zwischen zwei benachbarten Windungen ein Abstand in Längsrichtung der Spule vorhanden ist. Durch diese Lücke ist der Spulenkern nach außen hin frei, so dass das Halteelement sowohl mit dem Spulenkern als auch mit den beiden benachbarten Spulenwindungen eine Verbindung eingehen kann. Das aus Kunststoff bestehende Halteelement wird hier an dieser Stelle aufgespritzt. Es verbindet sich mit dem Spulenkern und mit den beiden benachbarten Windungen. Dadurch ist eine feste Verbindung zwischen dem Spulenkern und der Spulenwicklung gegeben, so dass die eingangs erwähnten Schwierigkeiten nicht mehr auftreten können.

Für eine automatische Montage vorgesehene Spulen haben in der Regel eine Ausbildung, die erkennen lässt, welches die für die Montage an der Leiterplatte vorgesehene Seite der Spule ist. Dies kann man beispielsweise dadurch erkennen, dass die beiden Anschlussenden der Spulenwicklung tangential zum Spulenkern verlaufen und in einer Ebene liegen. Die Erfindung schlägt nun vor, das Halteelement auf der der Montageseite der Spule abgewandten Seite der Spule anzuspritzen, oder auch anderes ausgedrückt, von dieser Seite her das Halteelement aufzuspritzen. Dies führt dazu, dass das Halteelement auch dazu verwendet werden kann, eine Angriffsstelle für eine Greifeinrichtung zu bilden, beispielsweise eine Ansaugpipette.

Erfindungsgemäß kann in Weiterbildung vorgesehen sein, dass das Halteelement sich mindestens über einen Teil des Umfangs der Spule erstreckt.

In nochmaliger Weiterbildung der Erfindung kann vorgesehen sein, dass das Halteelement sich nur über einen Teil der Länge der Spule erstreckt. Damit bleibt der Rest der Spule, insbesondere der Spulenwicklung, von dem Material des Halteelements frei, so dass keine Einschränkungen im Hinblick auf die Fähigkeit zur Wärmeabgabe auftreten.

Es kann aber auch vorgesehen sein, dass das Halteelement sich über einen gesamten Umfang der Spule herum erstreckt, so dass es also um die Spule herum gespritzt wird.

In nochmaliger Weiterbildung der Erfindung kann vorgesehen sein, dass das Halteelement auf der der Montageseite abgewandten Seite der Spule eine ebene Oberfläche aufweist. Diese ebene Oberfläche ist zum Angriff eines Greifers bestimmt und geeignet.

Erfindungsgemäß kann ebenfalls vorgesehen sein, dass das Halteelement aus einem Kunststoff gespritzt wird, der bei höheren Temperaturen eine Klebewirkung entfaltet, beispielsweise bei einer der Löttemperatur entsprechenden Temperatur. Dies führt dazu, dass die Spule bei ihrer durch Löten erfolgenden elektrischen Verbindung mit der Leiterplatte gleichzeitig auch zusätzlich noch an einer weiteren Stelle mechanisch verbunden wird.

Zur Herstellung der Spule schlägt die Erfindung vor, zunächst aus Draht die Spulenwicklung derart herzustellen, dass diese an mindestens einer Stelle eine Lücke zwischen zwei benachbarten Windungen in Längsrichtung aufweist. Anschließend wird in diese Spulenwicklung ein Spulenkern eingeschoben und die Einheit aus Spulenwicklung und Kern in eine Spritzform eingebracht. In dieser Spritzform können viele derartige Einheiten aus Spulenwicklung und Spulenkern eingebracht werden. Anschließend wird auf die erwähnte Stelle der Lücke zwischen den beiden Windungen und die beiden benachbarten Windungen selbst das Halteelement aufgespritzt.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung einer bevorzugten Ausführungsform der Erfindung sowie anhand der Zeichnung. Hierbei zeigen:
- Figur 1: die Ansicht einer Spulenwicklung mit einem Spulenkern aus der der Montageseite der Spule abgewandten Richtung;
- Figur 2: die Ansicht der Spule der Figur 1 von unten in Figur 1;
- Figur 3: die der Figur 2 entsprechende Ansicht der Spule mit einem aufgebrachten Halteelement;
- Figur 4: eine der Figur 3 entsprechende Darstellung bei einer zweiten Ausführungsform.

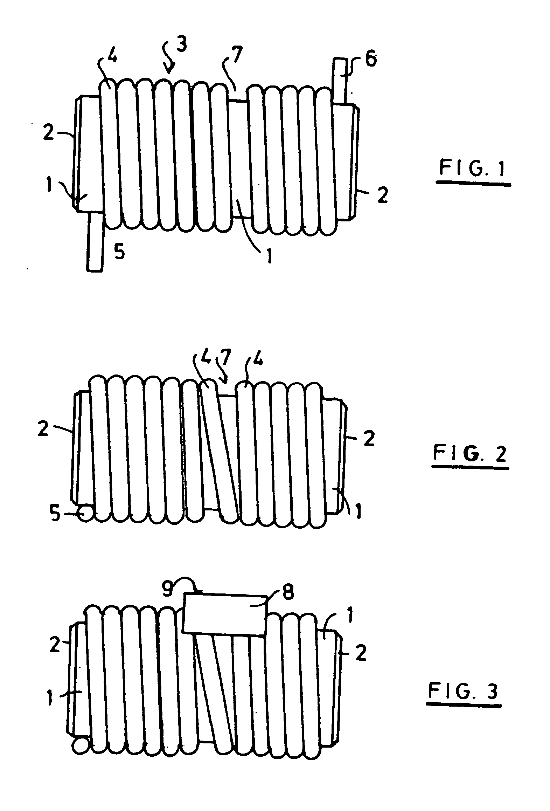

Figur 1 zeigt eine Spule mit einem Spulenkern 1, beispielsweise aus Ferrit. Der Spulenkern 1 ist als kreiszylindrischer Stab ausgebildet. Er enthält zwei ebene Stirnflächen 2. Der Spulenkern 1 ist von einer Spulenwicklung 3 umgeben, die eine Vielzahl von aneinander anliegenden Spulenwindungen 4 aufweist. Die beiden Enden 5, 6 der Spulenwicklung 3 sind tangential von dem Spulenkern 1 weg geführt. Die beiden Enden 5, 6 können auch länger sein, die Darstellung ist nur schematisch gedacht. Sie liegen in einer Ebene. Diese Ebene stellt die Montageseite der Spule dar.

Die Windungen 4 der Spulenwicklung 3 sind an einer Stelle 7 so gewickelt, dass sie dort einen Abstand in Längsrichtung der Spule aufweisen. Dadurch ist eine Lücke gebildet, durch die hindurch ein Teil der Oberfläche des Spulenkerns 1 sichtbar ist.

Figur 2 zeigt die Ansicht der Spule der Figur 1 von unten in Figur 1, also aus einer um 90 ° versetzten Richtung. Hier sieht man, wie der Abstand zwischen zwei benachbarten Windungen 4 zu Stande kommt. Die Steigung der Windungen wird an dieser Stelle vergrößert und anschließend wieder auf den normalen Wert zurückgeführt.

Die in den Figuren 1 und 2 dargestellte Einheit aus Spulenkern 1 und Spulenwicklung 3 wird dann in eine Spritzform gelegt, zusammen mit einer Vielzahl weiterer derartiger Einheiten. In dieser Spritzform wird ein Halteelement 8 auf die Stelle 7 des Abstands zwischen zwei benachbarten Windungen 4 der Spulenwicklung 3 aufgespritzt. Die in Figur 3 zu sehende Oberseite 9 des Halteelements 8 ist eben ausgebildet In Längsrichtung erstreckt sich das Halteelement 8 über die Lücke zwischen den benachbarten Windungen und mindestens noch über die beiden benachbarten Windungen selbst, vorzugsweise noch bis in die Vertiefung zwischen den nächsten Windungen. Das Halteelement 8 wird aus Kunststoff gespritzt und geht eine Verbindung mit dem Kern 1 und den Spulenwindungen ein. Dadurch wird auch die Spulenwicklung 3 selbst mit dem Kern 1 verbunden. Bei der Ausführungsform der Figur 3 erstreckt sich das Halteelement 8 in Umfangsrichtung nur über einen Teil der Spule.

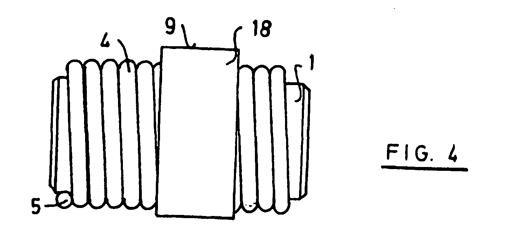

Figur 4 zeigt eine Ausführungsform, bei der das Halteelement 18 über den gesamten Umfang der Spule herum gespritzt ist. Wieder ist die der Montageseite, unten in Figur 4, abgewandte Seite des Halteelements 18 mit einer ebenen Oberfläche 9 versehen, an der ein Greifer angreifen kann.

Bei beiden Ausführungsformen erstreckt sich das Halteelement 8,18 nur über einen Teil der Länge der Spule, so dass die restlichen Windungen der Spulenwicklung 3 frei bleiben und ihre Wärme abgeben können.

Die Anbringung eines Halteelements 8,18 an einem elektronischen Bauteil wurde am Beispiel einer Spule beschrieben. Die Anbringung eines derartigen Halteelements kann aber auch bei sonstigen elektronischen Bauteilen erfolgen.

Das in Figur 4 dargestellte Halteelement 18 kann aus einem Kunststoff gespritzt sein, der bei einer der Löttemperatur entsprechenden Temperatur eine Klebewirkung entwickelt. Wenn die Spule auf die Leiterplatte aufgesetzt ist und dann anschließend angelötet wird, wird sie gleichzeitig mit Hilfe des Halteelements 18 mit der Oberfläche der Leiterplatte verklebt. Dies führt zu einer besonders guten mechanischen Sicherung der Spule an der Leiterplatte. Diese Art der Verbindung durch ein Halteelement aus einem bei höheren Temperaturen eine Klebewirkung erzeugenden Kunststoff kann auch bei anderen elektronischen Bauteilen Anwendung finden, nicht nur bei Spulen mit einem Spulenkern.

Was bei den Figuren 1 bis 4 für die liegende Anordnung von Spulen dargestellt wurde, ist natürlich auch für die stehende Anordnung von Spulen möglich. Bei der liegenden Anordnung verläuft die Achse des Spulenkerns und der Spulenwicklung parallel zu der Fläche, auf der die Spule angebracht wird. Bei der stehenden Anordnung verläuft diese Achse senkrecht zu der Fläche. Auch bei der stehenden Anordnung ist es möglich, das Halteelement so anzuordnen, wie es die Figuren 1 bis 3 zeigen. Auch dann kann ein Greifer an der Angriffsfläche 9 des Halteelements angreifen und die Spule an Ort und Stelle absetzen.

## Patentansprüche

1. Elektronisches Bauelement, das
1.1 als Spule mit einem **kreiszylindrischen** Spulenkern (1) und einer den Spulenkern (1) umgebenden Spulenwicklung (3) mit mindestens zwei Anschlussenden (5, 6) und
1.2 zur automatischen Bestückung ausgebildet ist und
1.3 ein Halteelement (8, 18, 28) aufweist, das
1.4 aus Kunststoff besteht und
1.5 an das elektronische Bauelement angespritzt ist und
1.6 als Angriffsstelle für einen Greifer ausgebildet ist,
**dadurch gekennzeichnet, dass**
1.7 an mindestens einer Stelle (7) zwischen zwei benachbarten Windungen (4) der Spulenwicklung (3) durch Vergrößerung der Steigung der Windungen (4) gegenüber dem restlichen Bereich ein Abstand in Längsrichtung der Spule vorhanden ist und
1.8 das Halteelement (8,18) an dem Spulenkern (1) an der Stelle (7) des Abstands zwischen den Windungen (4) und an mindestens den beiden dieser Stelle (7) benachbarten Windungen (4) der Spulenwicklung (3) angreift.

2. Bauelement nach Anspruch 1, bei dem das Halteelement (8,18) auf der der Montageseite der Spule abgewandten Seite der Spule angeordnet ist.

3. Bauelement nach einem der vorhergehenden Ansprüche, bei dem das Halteelement (8,18) sich über mindestens einen Teil des Umfangs des Bauelements erstreckt.

4. Bauelement nach einem der vorhergehenden Ansprüche, bei dem das Halteelement (8,18) sich nur über einen Teil der Länge des Bauelements erstreckt.

5. Bauelement nach einem der vorhergehenden Ansprüche, bei dem das Halteelement (18) sich über den gesamten Umfang des Bauelements herum erstreckt.

6. Bauelement nach einem der vorhergehenden Ansprüche, bei dem das Halteelement (8,18) auf der der Montageseite abgewandten Seite des Bauelements eine ebene Oberfläche (9) aufweist.

7. Bauelement nach einem der vorhergehenden Ansprüche, bei dem das Halteelement (8,18) aus einem Kunststoff gespritzt ist, der bei Löttemperatur klebend wirkt.

8. Verfahren zum Befestigen eines als Spule mit einem **kreiszylindrischen** Spulenkern (1) ausgebildeten elektronischen Bauelements, bei dem
8.1 die Windungen (4) der Spulenwicklung an mindestens einer Stelle (7) durch Vergrößerung der Steigung der Windungen (4) gegenüber dem restlichen Bereich mit einem Abstand versehen werden,
8.2 der Spulenkern (1) und die Spulenwicklung (3) in eine Spritzform eingebracht werden,
8.3 auf die Stelle (7) des Abstands zwischen den beiden Windungen (4) und die beiden Windungen (4) selbst ein Halteelement (8,18) angespritzt wird,
8.4 an dem Halteelement eine Angriffsfläche für einen Greifer ausgebildet wird, und
8.5 das Bauelement mit Hilfe eines an der Angriffsfläche angreifenden Greifers an seine Montagestelle befördert wird.

9. Verfahren nach Anspruch 8, bei dem das Halteelement (8,18) auf die der Montageseite des Bauelements abgewandte Seite des Bauelements angespritzt wird.

10. Verfahren nach Anspruche 8 oder 9, bei dem das Halteelement (8,18) über mindestens einen Teil des Umfangs des Bauelements angespritzt wird.

11. Verfahren nach einem der Ansprüche 8 bis 10, bei dem das Halteelement (8,18) nur über einen Teil der Länge des Bauelements angespritzt wird.

12. Verfahren nach einem der Ansprüche 8 bis 11, bei dem das Halteelement (18) über den gesamten Umfang des Bauelements herum gespritzt wird.

13. Verfahren nach einem der Ansprüche 8 bis 12, bei dem das Halteelement (8,18) auf der der Montageseite des Bauelements abgewandten Seite mit einer ebenen Oberfläche (9) versehen wird.

14. Verfahren nach einem der Ansprüche 8 bis 13, bei dem das Halteelement aus einem Kunststoff gespritzt wird, der bei einer der Löttemperatur entsprechenden Temperatur eine Klebewirkung entfaltet.

## Claims

1. An electronic component that
1.1 comprises a coil with a circular cylindrical coil core (1) and a coil winding (3) surrounding the coil core (1) with at least two connection ends (5, 6) and
1.2 is formed for automatic insertion and
1.3 features a holding element (8, 18, 28) that
1.4 consists of plastic and
1.5 is injection-moulded on the electronic component, and
1.6 is formed as an action point for a gripping device,
**characterised in that**
1.7 on at least one point (7) between two adjoining windings (4) of the coil winding (3), a gap is provided in the longitudinal direction of the coil due to enlargement of the pitch of the windings (4) relative to the remaining area,
1.8 the holding element (8, 18) acts on the coil core (1) on said point (7) of said gap between the windings (4), and on at least the two windings (4) of said coil winding (3) adjoining said point (7).

2. The component according to Claim 1, wherein the holding element (8, 18) is disposed on the side of the coil facing away from the assembly side of said coil.

3. The component according to one of the preceding claims, wherein the holding element (8, 18) extends over at least a part of the circumference of said component.

4. The component according to one of the preceding claims, wherein the holding element (8, 18) extends only over a part of the length of said component.

5. The component according to one of the preceding claims, wherein the holding element (18) extends around the entire circumference of said component.

6. The component according to one of the preceding claims, wherein the holding element (8, 18) features a plane surface (9) on the side of said component facing away from the assembly side.

7. The component according to one of the preceding claims, wherein the holding element (8, 18) is injection moulded of plastic that acts adhesively at soldering temperature.

8. A process for fixing an electronic component formed as coil with a circular cylindrical coil core (1), wherein
8.1 the windings (4) of the coil winding are provided with a gap at least at one point (7) due to enlargement of the pitch of the windings (4) relative to the remaining area,
8.2 the coil core (1) and the coil winding (3) are brought in an injection mould,
8.3 a holding element (8,18) is injection moulded on the point (7) of the gap between the two windings (4) and the windings (4) themselves,
8.4 an action surface for a gripping device is formed on the holding element, and
8.5 the component is conveyed to its assembly point with the help of a gripping device acting on the action surface.

9. The process according to Claim 8, wherein the holding element (8, 18) is injection moulded on the side of the component facing away from the assembly side of said component.

10. The process according to Claim 8 or 9, wherein the holding element (8, 18) is injection moulded over at least a part of the circumference of the component.

11. The process according to one of Claims 8 to 10, wherein the holding element (8, 18) is injection moulded only over a part of the length of the component.

12. The process according to one of Claims 8 to 11, wherein the holding element (18) is injection moulded all around the entire circumference of the component.

13. The process according to one of Claims 8 to 12, wherein the holding element (8, 18) is provided with a plane surface (9) on the side of the component facing away from the assembly side.

14. The process according to one of Claims 8 to 13, wherein the holding element is injection moulded of plastic that exhibits adhesive effect at a temperature that corresponds to the soldering temperature.

## Revendications

1. Composant électronique qui
1.1 est réalisé comme bobine comprenant un noyau de bobine (1) en forme de cylindre circulaire et un enroulement à bobine (3), entourant le noyau de bobine (1), muni d'au moins deux extrémités de raccordement (5, 6) et
1.2 pour l'insertion automatique, et
1.3 qui présente un élément de maintien (8, 18, 28) qui
1.4 est constitué de matière plastique et
1.5 est injecté sur le composant électronique et
1.6 est réalisé comme endroit d'attaque pour un outil de préhension, **caractérisé en ce que**
1.7 à au moins un endroit (7) entre deux spires adjacentes (4) de l'enroulement à bobine (3) un écart est présent dans le sens longitudinal de la bobine par agrandissement du pas des spires (4) par rapport à la région restante,
1.8 l'élément de maintien (8, 18) a prise sur le noyau de bobine (1) à l'endroit (7) de l'écart entre les spires (4) et sur au moins les deux spires (4) de l'enroulement à bobine (3) adjacentes à cet endroit (7).

2. Composant selon la revendication 1, dans lequel l'élément de maintien (8, 18) est disposé sur le côté de la bobine détourné du côté de montage de la bobine.

3. Composant selon l'une quelconque des revendications précédentes, dans lequel l'élément de maintien (8, 18) s'étend sur au moins une partie de la circonférence du composant.

4. Composant selon l'une quelconque des revendications précédentes, dans lequel l'élément de maintien (8, 18) s'étend seulement sur une partie de la longueur du composant.

5. Composant selon l'une quelconque des revendications précédentes, dans lequel l'élément de maintien (18) s'étend autour de toute la circonférence du composant.

6. Composant selon l'une quelconque des revendications précédentes, dans lequel l'élément de maintien (8, 18) présente une surface plane (9) sur le côté du composant détourné du côté de montage.

7. Composant selon l'une quelconque des revendications précédentes, dans lequel l'élément de maintien (8, 18) est injecté à partir d'une matière plastique qui, à la température de soudage, agit en collant.

8. Procédé de fixation d'un composant électronique réalisé comme bobine comprenant un noyau de bobine (1) en forme de cylindre circulaire, dans lequel
8.1 les spires (4) de l'enroulement à bobine sont munies d'un écart à au moins un endroit (7) par agrandissement du pas des spires (4) par rapport à la région restante,
8.2 le noyau de bobine (1) et l'enroulement à bobine (3) sont insérés dans un moule à injection,
8.3 un élément de maintien (8, 18) est injecté sur l'endroit (7) de l'écart entre les deux spires (4) et les deux spires (4) elles-mêmes,
8.4 une surface d'attaque pour un outil de préhension est réalisée sur l'élément de maintien, et
8.5 le composant est transporté à son endroit de montage à l'aide d'un outil de préhension ayant prise sur la surface d'attaque.

9. Procédé selon la revendication 8, dans lequel l'élément de maintien (8, 18) est injecté sur le côté du composant détourné du côté de montage du composant.

10. Procédé selon la revendication 8 ou 9, dans lequel l'élément de maintien (8, 18) est injecté sur au moins une partie de la circonférence du composant.

11. Procédé selon l'une quelconque des revendications 8 à 10, dans lequel l'élément de maintien (8, 18) est injecté seulement sur une partie de la longueur du composant.

12. Procédé selon l'une quelconque des revendications 8 à 11, dans lequel l'élément de maintien (18) est injecté autour de toute la circonférence du composant.

13. Procédé selon l'une quelconque des revendications 8 à 12, dans lequel l'élément de maintien (8, 18) est muni d'une surface plane (9) sur le côté détourné du côté de montage du composant.

14. Procédé selon l'une quelconque des revendications 8 à 13, dans lequel l'élément de maintien est injecté à partir d'une matière plastique qui, à une température correspondant à la température de soudage, déploie un effet de collage.
